# EUROPEAN PATENT APPLICATION

(11) **EP 4 345 880 A1**
(43) Date of publication of application: **03.04.2024**
(21) Application number: 23193414.2
(22) Date of filing: 25.08.2023
(51) Int. Cl.: H01L 21/8234, H01L 27/088, H01L 29/06, H01L 29/66, H01L 29/775, H01L 29/786

(54) **HIGH ASPECT RATIO METAL GATE CUTS**

(30) Priority: 27.09.2022 US 202217953873
(71) Applicant: INTEL Corporation, Santa Clara, CA 95054 (US)
(72) Inventor: BAYATI, Reza, Portland, 97229 (US); PRINCE, Matthew, Portland, 97229 (US); DAVIS, Alison, Portland, 97225 (US); GHOSTINE, Ramy, Portland, 97229 (US); SINHA, Piyush, Portland, 97229 (US); GOLONZKA, Oleg, Beaverton, 97007 (US); GHOSH, Swapnadip, Hillsboro, 97124 (US); SHARMA, Manish, Portland, 97229 (US)
(74) Representative: 2SPL Patentanwälte PartG mbB

(57) **Abstract**

Techniques are provided herein to form semiconductor devices (101, 103) that include one or more gate cuts (120) having a very high aspect ratio (e.g., an aspect ratio of 5:1 or greater, such as 10: 1). In an example, a semiconductor device includes a conductive material (118a, 118b) that is part of a transistor gate structure around or otherwise on a semiconductor region. The semiconductor region can be, for example, a fin of semiconductor material that extends between a source region and a drain region, or one or more nanowires or nanoribbons of semiconductor material (104) that extend between a source region and a drain region. The gate structure may be interrupted between two transistors (101, 103) with a gate cut (120) that extends through an entire thickness of the gate structure. A particular plasma etching process may be performed to form the gate cut with a very high height-to-width aspect ratio so as to enable densely integrated devices.

## Description

### FIELD OF THE DISCLOSURE

The present disclosure relates to integrated circuits, and more particularly, to metal gate cuts made in semiconductor devices.

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices that illustrate a gate cut between devices having a high aspect ratio, in accordance with an embodiment of the present disclosure.
Figures 2A - 2N are cross-sectional views that illustrate various stages in an example process for forming semiconductor devices that have a high aspect ratio gate cut, in accordance with some embodiments of the present disclosure.
Figure 3 illustrates a cross-sectional view of a chip package containing one or more semiconductor dies, in accordance with some embodiments of the present disclosure.
Figure 4 is a flowchart of a fabrication process for semiconductor devices having a gate cut with a high aspect ratio, in accordance with an embodiment of the present disclosure.
Figure 5 is a flowchart of a more detailed fabrication process for forming the gate cut with the high aspect ratio, in accordance with an embodiment of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include one or more gate cuts having a very high height-to-width aspect ratio (e.g., an aspect ratio of 5:1 or greater, such as 10:1 or 11:1). The techniques can be used in any number of integrated circuit applications and are particularly useful with respect to device layer transistors, such as finFETs or gate-all-around transistors (e.g., ribbonFETs and nanowire FETs). In an example, a semiconductor device includes a gate structure around or otherwise on a semiconductor region. The semiconductor region can be, for example, a fin of semiconductor material that extends from a source region to a drain region, or one or more nanowires or nanoribbons of semiconductor material that extend from a source region to a drain region. The gate structure includes a gate dielectric (e.g., high-k gate dielectric material) and a gate electrode (e.g., conductive material such as workfunction material and/or gate fill metal). The gate structure may be interrupted, for example, between two transistors with a gate cut that extends through an entire thickness of the gate structure and includes a dielectric material to electrically isolate the portions of the gate structure on either side of the gate cut. A particular plasma etching process may be performed to form the gate cut with a very high height-to-width aspect ratio (e.g., 5:1 or higher, or 10:1 or higher, or 11:1 or higher) and low to no taper, so as to enable densely integrated devices. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Example structures like gate cuts are used in integrated circuit design to isolate gate structures from one another. One possible way to form gate cuts is to use a gate patterning scheme that uses the poly-cut flow, where the gate cut is formed prior to formation of the final metal gate. Another approach might be to use a gate patterning scheme that uses the metal gate cut flow. Such approaches generally etch a trench or other recess through a thickness of the poly or metal gate structure and fill the trench with a dielectric material. Gate cuts formed after the formation of the metal gate structures may have some benefits over gate cuts formed during poly-cut flow. However, such metal gate cuts tend to be relatively wide at the trench opening and/or include a significant amount of taper from the top to bottom of the gate cut (e.g., sidewall taper of more than 8 nm). This is especially true for gate cuts having a high length-to-width aspect ratio (e.g., 5:1 or higher).

Thus, and in accordance with an embodiment of the present disclosure, techniques are provided herein to form high length-to-width aspect ratio gate cuts through a metal gate structure. The gate cuts have an aspect ratio of 5:1 or higher, such as 9:1, 10:1, 11:1, or even greater. A plasma-based etching process is described that delivers sidewalls with a nearly vertical profile (e.g., sidewall taper of less than 2 nm or a sidewall angle between 87° and 90°), and good selectively to dielectric spacers, mask material, and epitaxial regions (e.g., source or drain regions). The plasma etching process demonstrates superior selectivity, allows for operation/variability reduction, demonstrates superior material compatibility, and has demonstrated manufacturability reduction cost by about 25-35%.

According to some embodiments, the plasma etching process uses a repeated series of finely-tuned passivation and etching processes to slowly etch portions of the gate electrode to maintain verticality (low to no taper) throughout the etching process. Different etch chemistries are used to break through the passivation layer and to etch the metal of the gate electrode. Furthermore, various flash operations may be performed during each cycle to remove etch byproducts from the sidewalls and to further protect the sidewalls from future etch cycles (e.g., preserving the verticality of the etch). Further details of the plasma etching process are described below.

According to an embodiment, an integrated circuit includes a first semiconductor device having a first semiconductor region extending in a first direction from a first source region to a first drain region, and a first gate structure extending in a second direction over the first semiconductor region, a second semiconductor device having a second semiconductor region extending in the first direction from a second source region to a second drain region, and a second gate structure extending in the second direction over the second semiconductor region, and a gate cut between and separating the first gate structure and the second gate structure. The gate cut includes a dielectric material and has a height-to-width aspect ratio of at least 5:1, such as, for example, at least 9:1 or at least 10:1. The first and second semiconductor regions may be fins of semiconductor material, or may each include a plurality of semiconductor nanoribbons or nanowires extending lengthwise in the first direction.

According to an embodiment, an integrated circuit includes a first semiconductor device having a first semiconductor region extending in a first direction from a first source region to a first drain region, and a first gate structure extending in a second direction over the first semiconductor region, a second semiconductor device having a second semiconductor region extending in the first direction from a second source region to a second drain region, and a second gate structure extending in the second direction over the second semiconductor region, and a gate cut between and separating the first gate structure and the second gate structure. The gate cut includes a dielectric material and has less than 2 nm of sidewall taper between the top surface of the first gate structure and the second gate structure and a bottom surface of the first gate structure and the second gate structure.

According to another embodiment, a method of forming an integrated circuit includes forming a first fin comprising semiconductor material and a second fin comprising semiconductor material, the first and second fins extending above a substrate and each extending in a first direction; forming a gate structure extending over the first fin and the second fin in a second direction different from the first direction; forming a recess through the gate structure between the first fin and the second fin; and forming a dielectric material within the recess. Forming the recess through the gate structure further includes (i) forming an opening through a hard mask layer over the gate structure, (ii) forming a liner material within the opening, (iii) forming a passivation layer within the opening, (iv) etching through at least the passivation layer at the bottom of the opening, (v) etching through a portion of the gate structure, and (vi) repeating (iii) - (v) until the recess extends through at least an entire thickness of the gate structure.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a gate cut having a height-to-width aspect ratio of greater than 5:1, or 10:1 or higher. In some such examples, the gate cut may have less than 2 nm of sidewall taper between a top surface of the surrounding gate structure and a bottom surface of the surrounding gate structure. Certain SEM or TEM cross-sections through the gate trench may also show that a gate dielectric on the semiconductor regions is not present on any sidewall of the gate cut. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

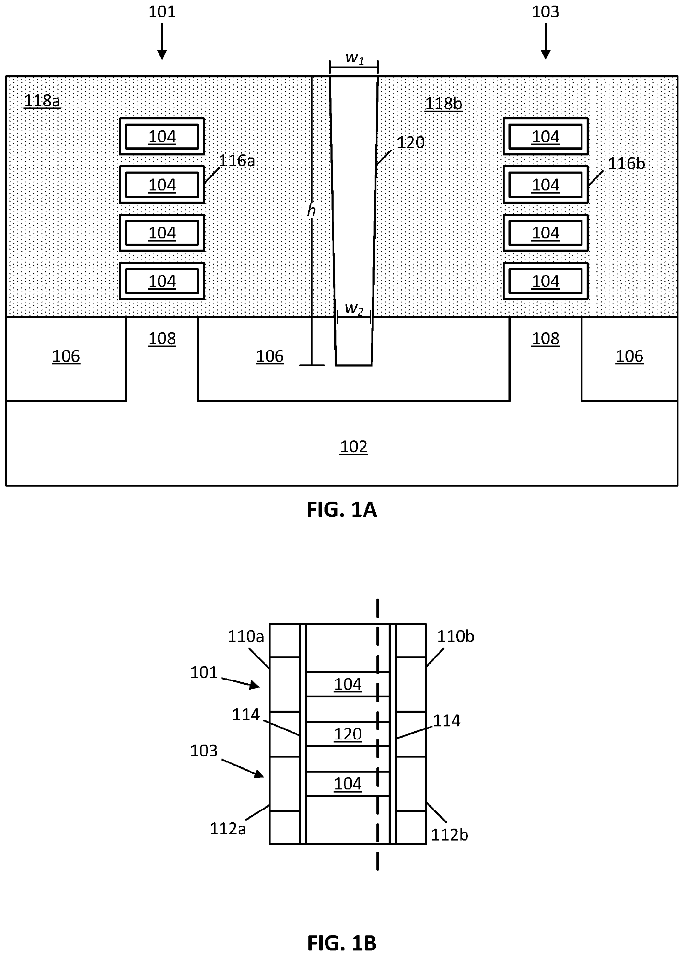

Figure 1A is a cross sectional view taken across two example semiconductor devices 101 and 103, according to an embodiment of the present disclosure. Figure 1B is a top-down view of the adjacent semiconductor devices 101 and 103 where Figure 1A illustrates the cross section taken across the dashed line. It should be noted that some of the material layers (such as gate electrode 118a and 118b) in the top-down view of Figure 1B have been omitted for clarity. Each of semiconductor devices 101 and 103 may be non-planar metal oxide semiconductor (MOS) transistors, such as tri-gate (e.g., finFET) or gate-all-around (GAA) transistors, although other transistor topologies and types could also benefit from the techniques provided herein. The illustrated embodiments herein use the GAA structure. Semiconductor devices 101 and 103 represent a portion of an integrated circuit that may contain any number of similar semiconductor devices.

As can be seen, semiconductor devices 101 and 103 are formed on a substrate 102. Any number of semiconductor devices can be formed on substrate 102, but two are used here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, a lower portion of (or all of) substrate 102 is removed and replaced with one or more backside interconnect layers to form backside signal and power routing.

Each of semiconductor devices 101 and 103 includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. The term nanoribbon may also encompass other similar shapes such as nanowires or nanosheets. The semiconductor material of nanoribbons 104 may be formed from substrate 102. In some embodiments, semiconductor devices 101 and 103 may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches.

As can further be seen, adjacent semiconductor devices are separated by a dielectric fill 106 that may include silicon oxide. Dielectric fill 106 provides shallow trench isolation (STI) between any adjacent semiconductor devices. Dielectric fill 106 can be any suitable dielectric material, such as silicon dioxide, aluminum oxide, or silicon oxycarbonitride.

Semiconductor devices 101 and 103 each include a subfin region 108. According to some embodiments, subfin region 108 comprises the same semiconductor material as substrate 102 and is adjacent to dielectric fill 106. According to some embodiments, nanoribbons 104 (or other semiconductor bodies) extend between a source and a drain region in the first direction to provide an active region for a transistor (e.g., the semiconductor region beneath the gate). The source and drain regions are not shown in the cross-section of Figure 1A, but are seen in the top-down view of Figure 1B where nanoribbons 104 of semiconductor device 101 extend between a source region 110a and a drain region 110b (similarly, the nanoribbons 104 of semiconductor device 103 extend between a source region 112a and a drain region 112b). Figure 1B also illustrates spacer structures 114 that extend around the ends of nanoribbons 104 and along sidewalls of the gate structures between spacer structures 114. Spacer structures 114 may include a dielectric material, such as silicon nitride.

According to some embodiments, the source and drain regions are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

According to some embodiments, a first gate structure extends over nanoribbons 104 of semiconductor device 101 along a second direction across the page while a second gate structure extends over nanoribbons 104 of semiconductor device 103 along the second direction. Each gate structure includes a respective gate dielectric 1 16a/116b and a gate layer (or gate electrode) 118a/118b. Gate dielectric 116a/116b represents any number of dielectric layers present between nanoribbons 104 and gate layer 118a/118b. Gate dielectric 116a/116b may also be present on the surfaces of other structures within the gate trench, such as on subfin region 108. Gate dielectric 116a/116b may include any suitable gate dielectric material(s). In some embodiments, gate dielectric 116a/116b includes a layer of native oxide material (e.g., silicon oxide) on the nanoribbons or other semiconductor regions making up the channel region of the devices, and a layer of high-K dielectric material (e.g., hafnium oxide) on the native oxide.

Gate layer 118a/118b may represent any number of conductive layers, such as any metal, metal alloy, or doped polysilicon layers. In some embodiments, gate layer 118a/118b includes one or more workfunction metals around nanoribbons 104. In some embodiments, one of semiconductor devices 101 and 103 is a p-channel device that include a workfunction metal having titanium around its nanoribbons 104 and the other semiconductor device is an n-channel device that includes a workfunction metal having tungsten around its nanoribbons 104. Gate layer 118a/118b may also include a fill metal or other conductive material around the workfunction metals to provide the whole gate electrode structure.

According to some embodiments, adjacent gate structures may be separated along the second direction (e.g., across the page) by a gate cut 120, which acts like a dielectric barrier between gate structures. Gate cut 120 may be formed from a sufficiently insulating material, such as a dielectric material. Example materials for gate cut 120 include silicon nitride, silicon oxide, or silicon oxynitride. In some embodiments, gate cut 120 includes more than one dielectric material, such as a dielectric layer at its edges and a separate dielectric fill. The dielectric layer may include a high-k dielectric material and the dielectric fill may include a low-k dielectric material.

According to some embodiments, gate cut 120 has a very high height-to-width aspect ratio due to the fabrication process discussed in more detail herein. For example, gate cut 120 may have an aspect ratio of 10:1 or greater. According to some embodiments, gate cut 120 has a total height h that extends through an entire thickness of gate layers 118a/118b and into at least a portion of dielectric fill 106. Height h may be, for instance, greater than 140 nm, such as between about 150 nm and about 200 nm (e.g., between about 160 nm and about 180 nm). According to some embodiments, gate cut 120 has a first width *w₁* at a top surface of gate cut 120 which is also at a top surface of the first gate structure (e.g., gate layer 118a) and a top surface of the second gate structure (e.g., gate layer 118b), and a second width *w₂* at a portion of gate cut 120 that crosses a bottom surface of the first gate structure (e.g., gate layer 118a) and a bottom surface of the second gate structure (e.g., gate layer 118b). In some examples, *w₁* is at most 2 nm greater than *w₂*, or at most 1.5 nm greater than *w₂*, or at most 1 nm greater than *w₂.* In some examples, *w₁* is at most 10% greater, at most 8% greater, or at most 5% greater than *w₂.* In some examples, *w₁* is less than 24 nm, such as the example case where *w₁* is between about 15 nm and about 20 nm and *w₂* is between about 14 nm and about 19 nm.

Gate cut 120 also extends in the first direction as seen in Figure 1B such that it cuts across at least the entire width of the gate trench. According to some embodiments, gate cut 120 may also extend further past spacer structures 114. In some examples, gate cut 120 extends across more than one gate trench in the first direction (e.g., cutting through more than one gate structure running parallel along the second direction).

### Fabrication Methodology

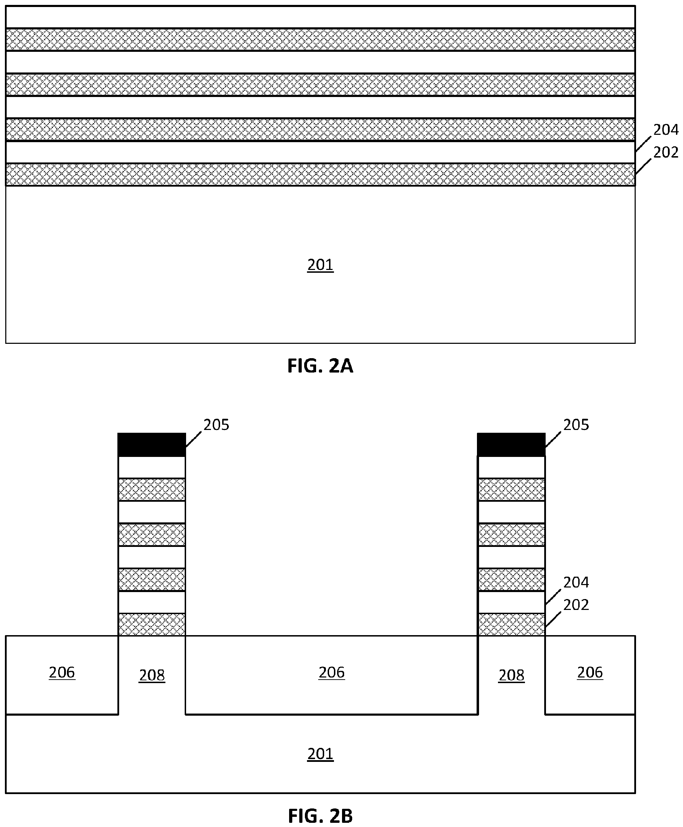

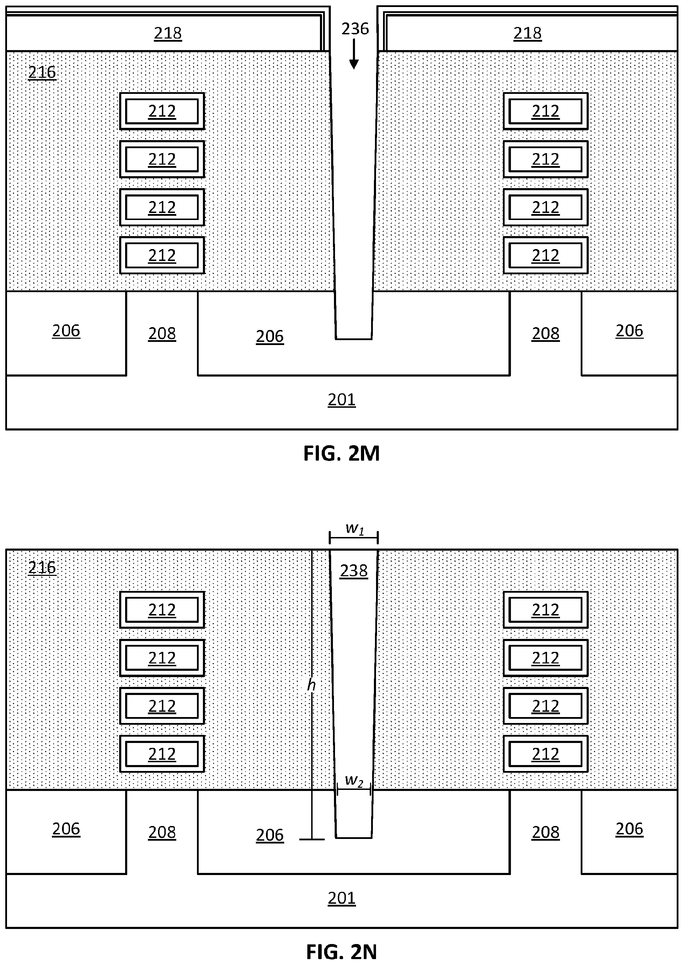

Figures 2A - 2N include cross-sectional views that collectively illustrate an example process for forming an integrated circuit with semiconductor devices and one or more gate cuts having a high height-to-width aspect ratio, in accordance with an embodiment of the present disclosure. Each figure shows an example structure that results from the process flow up to that point in time, so the depicted structure evolves as the process flow continues, culminating in the structure shown in Figure 2N, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated. Although the fabrication of a single gate cut is illustrated in the aforementioned figures, it should be understood that any number of similar gate cuts can be fabricated across the integrated circuit using the same processes discussed herein.

Figure 2A illustrates a cross-sectional view taken through a substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. The description above for substrate 102 applies equally to substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A following the formation of a cap layer 205 and the subsequent formation of fins beneath cap layer 205, according to an embodiment. Cap layer 205 may be any suitable hard mask material such as a carbon hard mask (CHM) or silicon nitride. Cap layer 205 is patterned into rows to form corresponding rows of fins from the alternating layer stack of sacrificial layers 202 and semiconductor layers 204. The rows of fins extend lengthwise in a first direction (e.g., into and out of the page).

According to some embodiments, an anisotropic etching process through the layer stack continues into at least a portion of substrate 201. The etched portion of substrate 201 may be filled with a dielectric fill 206 that acts as shallow trench isolation (STI) between adjacent fins. Dielectric fill 206 may be any suitable dielectric material such as silicon oxide. Subfin regions 208 represent remaining portions of substrate 201 between dielectric fill 206, according to some embodiments.

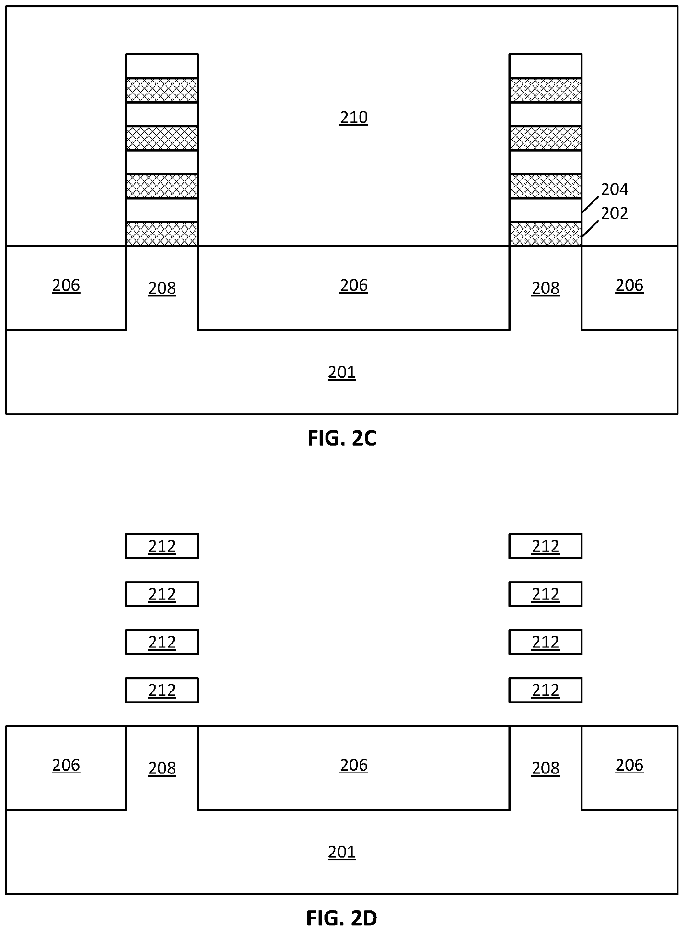

Figure 2C depicts the cross-section view of the structure shown in Figure 2B following the formation of a sacrificial gate 210 extending across the fins in a second direction different from the first direction, according to some embodiments. Sacrificial gate 210 may extend across the fins in a second direction that is orthogonal to the first direction. According to some embodiments, the sacrificial gate material is formed in parallel strips across the integrated circuit and removed in all areas not protected by a gate masking layer. Sacrificial gate 210 may be any suitable material that can be selectively removed without damaging the semiconductor material of the fins. In some examples, sacrificial gate 210 includes polysilicon.

Following the formation of sacrificial gate 210 (and prior to replacement of sacrificial gate 210 with a metal gate), additional semiconductor device structures are formed that are not shown in these cross-sections. These additional structures include spacer structures on the sidewalls of sacrificial gate 210 and source and drain regions on either ends of each of the fins. The formation of such structures would be well understood to a person skilled in the relevant art.

Figure 2D depicts the cross-section view of the structure shown in Figure 2C following the removal of sacrificial gate 210 and the removal of sacrificial layers 202, according to some embodiments. In examples where any gate masking layers are still present, they would also be removed at this time. Once sacrificial gate 210 is removed, the fins that had been beneath sacrificial gate 210 are exposed.

In the example where the fins include alternating semiconductor layers, sacrificial layers 202 are selectively removed to release nanoribbons 212 that extend between corresponding source or drain regions. Each vertical set of nanoribbons 212 represents the semiconductor region of a different semiconductor device. It should be understood that nanoribbons 212 may also be nanowires or nanosheets. Sacrificial gate 210 and sacrificial layers 202 may be removed using the same isotropic etching process or different isotropic etching processes.

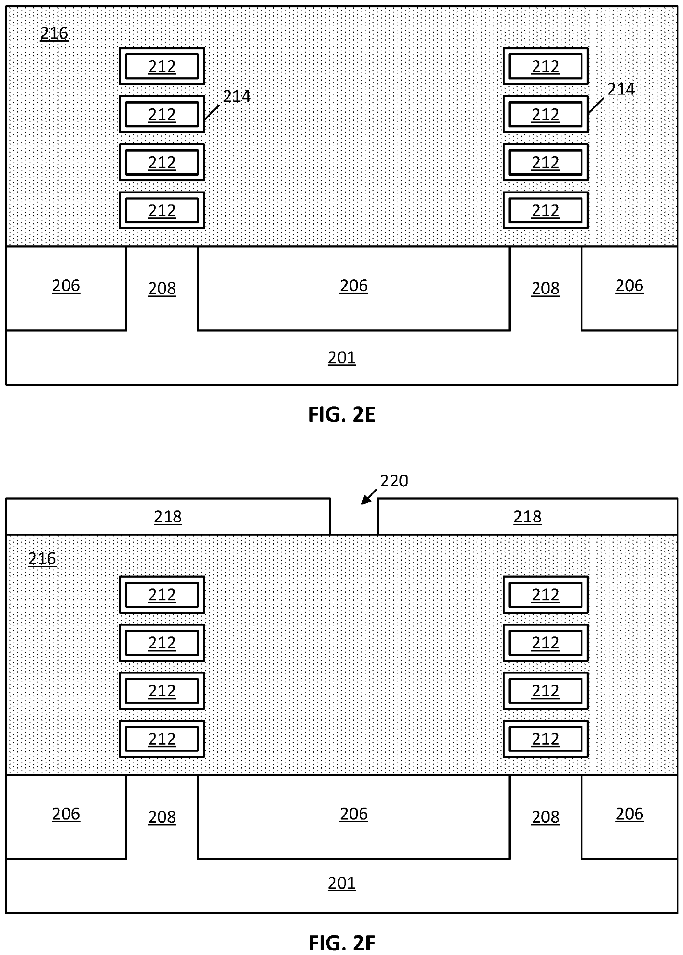

Figure 2E depicts the cross-section view of the structure shown in Figure 2D following the formation of a gate structure and subsequent polishing, according to some embodiments. The gate structure includes a gate dielectric 214 and a conductive gate electrode 216. Gate dielectric 214 may be first formed around nanoribbons 212 prior to the formation of gate electrode 216. The gate dielectric 214 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 214 includes a layer of hafnium oxide with a thickness between about 1 nm and about 5 nm. In some embodiments, gate dielectric 214 may include one or more silicates (e.g., titanium silicate, tungsten silicate, niobium silicate, and silicates of other transition metals). In some cases, gate dielectric 214 may include a first layer on nanoribbons 212, and a second layer on the first layer. The first layer can be, for instance, an oxide of the semiconductor material of nanoribbons 212 (e.g., silicon dioxide) and the second layer can be a high-k dielectric material (e.g., hafnium oxide). More generally, gate dielectric 214 can include any number of dielectric layers. According to some embodiments, gate dielectric 214 forms along all surfaces exposed within the gate trench, such as along inner sidewalls of the spacer structures and along the top surfaces of dielectric fill 206 and subfin regions 208.

As noted above, gate electrode 216 can represent any number of conductive layers. The conductive gate electrode 216 may be deposited using electroplating, electroless plating, CVD, PECVD, ALD, or PVD, to name a few examples. In some embodiments, gate electrode 216 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 216 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished such that the top surface of the gate structure (e.g., top surface of gate electrode 216) is planar with the top surface of other semiconductor elements, such as the spacer structures that define the gate trench..

Figure 2F illustrates another cross-section view of the structure shown in Figure 2E following the formation of a masking structure 218, according to some embodiments. Masking structure 218 may include any number of hard mask layers, such as any dielectric layers or carbon hard mask layers. An opening 220 may be formed through masking layer 218 to expose a portion of gate electrode 216 where a gate cut will be formed. A reactive ion etching (RIE) process may be used to form opening 220.

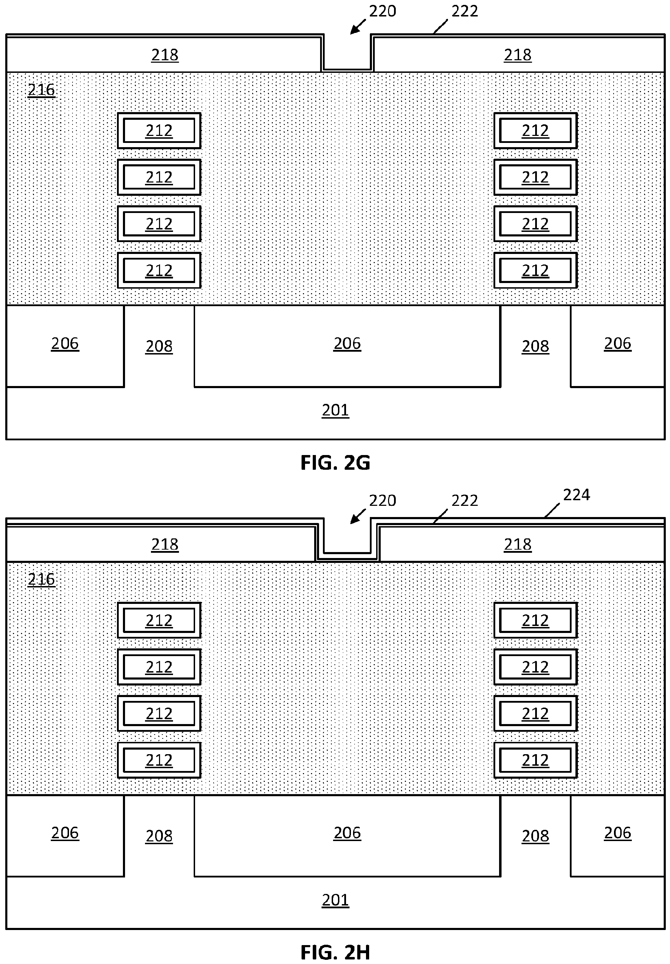

Figure 2G illustrates another cross-section view of the structure shown in Figure 2F following the formation of liner layer 222 within opening 220, according to some embodiments. Liner layer 222 may be formed using atomic layer deposition (ALD) or plasma enhanced atomic layer deposition (PEALD) in a chamber with a pressure between 80 mTorr - 100 mTorr, a temperature between 90 °C and 140 °C, and gases containing helium and oxygen. In some embodiments, liner layer 222 includes a dielectric material, such as silicon oxide or other oxide-based material. Liner layer 222 may be provided to tune the critical dimension of the top width of the resulting gate cut. Due to its conformal structure, liner layer 222 forms on the top surface of the exposed gate electrode 216 and on sidewall surfaces of opening 220.

Figure 2H illustrates another cross-section view of the structure shown in Figure 2G following the formation of a passivation layer 224 on liner layer 222 within opening 220, according to some embodiments. In some embodiments, passivation layer 224 includes a dielectric material, such as silicon oxide. Passivation layer 224 may be deposited using chemical vapor deposition (CVD) or plasma enhanced chemical vapor deposition (PECVD) in a chamber with a pressure between 5 mTorr - 20 mTorr, a temperature between 90 °C and 140 °C, and gases containing helium, oxygen, and silicon tetrachloride (SiCl₄). The gases may be introduced into the chamber at different flow rates. For example, helium may be introduced at a flow rate between 400 and 800 sccm, oxygen may be introduced at a flow rate between 50 and 100 sccm, and SiCl₄ may be introduced at a flow rate between 70 and 120 sccm.

According to some embodiments, the CVD or PECVD process used to form passivation layer 224 may have two different deposition processes with a different RF power applied in each process. For example, a first CVD deposition may be performed using either no applied RF power or a first RF power between 1 W and 3000 W, and a second CVD deposition may be performed using a second RF power that is different from the first RF power. Using two different CVD deposition processes to form passivation layer 224 may balance the deposited amount of passivation layer 224 over the top surface of masking structure 218 outside of opening 220 to protect mmnasking structure 218 with the deposited amount of passivation layer 224 on the sidewalls within opening 220 to prevent or minimize lateral etching.

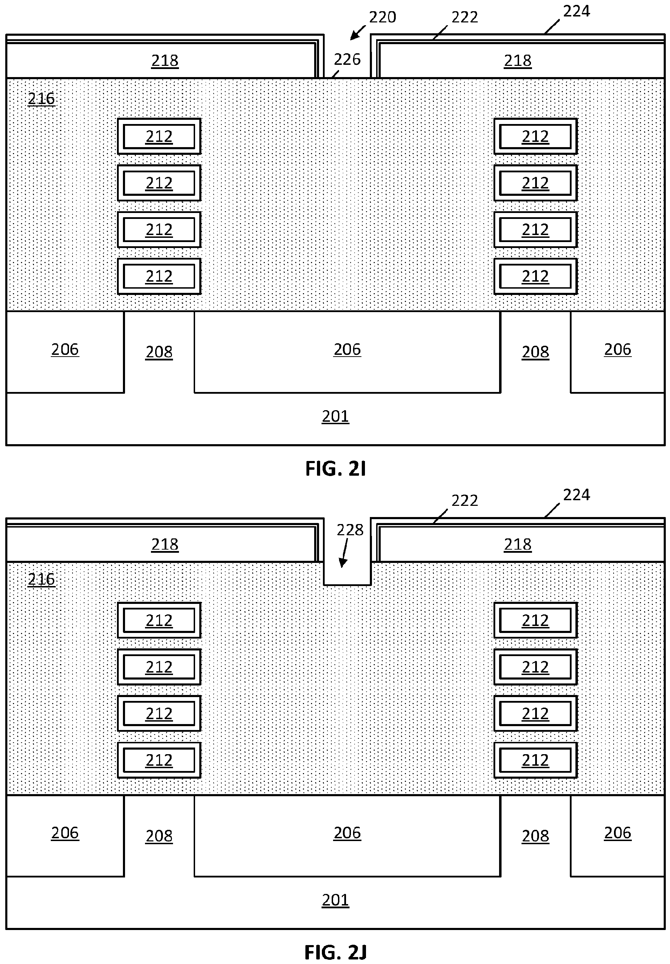

Figure 2I illustrates another cross-section view of the structure shown in Figure 2H following an etching process to break through the portions of liner layer 222 and passivation layer 224 on the bottom surface (e.g., the etch front) of opening 220 to expose a surface portion 226 of gate electrode 216, according to some embodiments. Portions of liner layer 222 and passivation layer 224 extending along the top surface of masking structure 218 may also be removed during this etching process, such that only portions of liner layer 222 and passivation layer 224 on the sidewalls of opening 220 remain. An RIE etching process may be used to punch through the portions of liner layer 222 and passivation layer 224 on the bottom surface of opening 220. According to some embodiments, the RIE process takes place in chamber having a pressure between 5 mTorr and 20 mTorr, a temperature between 90 °C and 140 °C, and gases containing helium, one or more hydrocarbons such as methane (CH₄), and one or more fluoro-hydrocarbons such as carbon tetrafluoride (CF₄) or fluoroform (CHF₃). The gases may be introduced into the chamber at different flow rates. For example, helium may be introduced at a flow rate between 50 and 150 sccm, CH₄ may be introduced at a flow rate between 50 and 150 sccm, and CHF₃ may be introduced at a flow rate between 5 and 30 sccm. The use of CH₄ during the etching process can help with adding carbon-based passivation to the sidewalls and can also reduce the etching of any exposed portions of the source or drain regions.

Figure 2J illustrates another cross-section view of the structure shown in Figure 2I following an etching process to remove a portion of gate electrode 216 thus extending opening 228 deeper, according to some embodiments. The etching process may be tuned to selectively etch the metal material of gate electrode 216. An RIE etching process may be used to etch a recess into the exposed surface 226 of gate electrode 216. According to some embodiments, the RIE process takes place in chamber having a pressure between 10 mTorr and 25 mTorr, a temperature between 90 °C and 140 °C, and gases containing boron trichloride (BC1₃), argon, and methane (CH₄). The gases may be introduced into the chamber at different flow rates. For example, BCl₃ may be introduced at a flow rate between 100 and 300 sccm, CH₄ may be introduced at a flow rate between 10 and 40 sccm, and argon may be introduced at a flow rate between 100 and 300 sccm. According to some embodiments, a high RF power may also be applied in the chamber between 1000 W and 3000 W to help break down the BCl₃ molecules and reduce the buildup of undesirable surface residue. The CH4 may once again be used to help reduce the etching of any exposed portions of the source or drain regions. In some embodiments, an additional bias RF power between 0 and 1000 W is applied to a chuck holding the wafer to vertically direct the species and reactants to the etch front.

Following the etch of a portion of gate electrode 216, any number of flash operations may be performed to help remove certain byproducts and/or other materials left behind. According to some embodiments, a first flash operation may be performed in a chamber having a pressure between 5 mTorr and 10 mTorr, a temperature between 90 °C and 140 °C, and gases containing argon, hydrogen, chlorine, methane (CH₄), helium, and oxygen. The first flash operation may be used to remove any polymer byproducts left behind from the metal etching process and/or to passivate any exposed portions of the source or drain regions. According to some embodiments, a second flash operation may be performed in a chamber having a pressure between 5 mTorr and 10 mTorr, a temperature between 90 °C and 140°C, and gases containing methane (CH₄) and helium. The second flash operation may be used to particularly remove any polymer byproducts from the sidewalls to prevent sidewall corrosion. According to some embodiments, a third flash operation may be performed in a chamber having a pressure between 5 mTorr and 25 mTorr, a temperature between 90 °C and 140 °C, and a gas containing oxygen. The third flash operation may be used to cure some boron-based polymers left behind on the sidewalls to enhance the sidewall protection for later etching processes. Any of these example flash operations may be performed and they may be performed in any order.

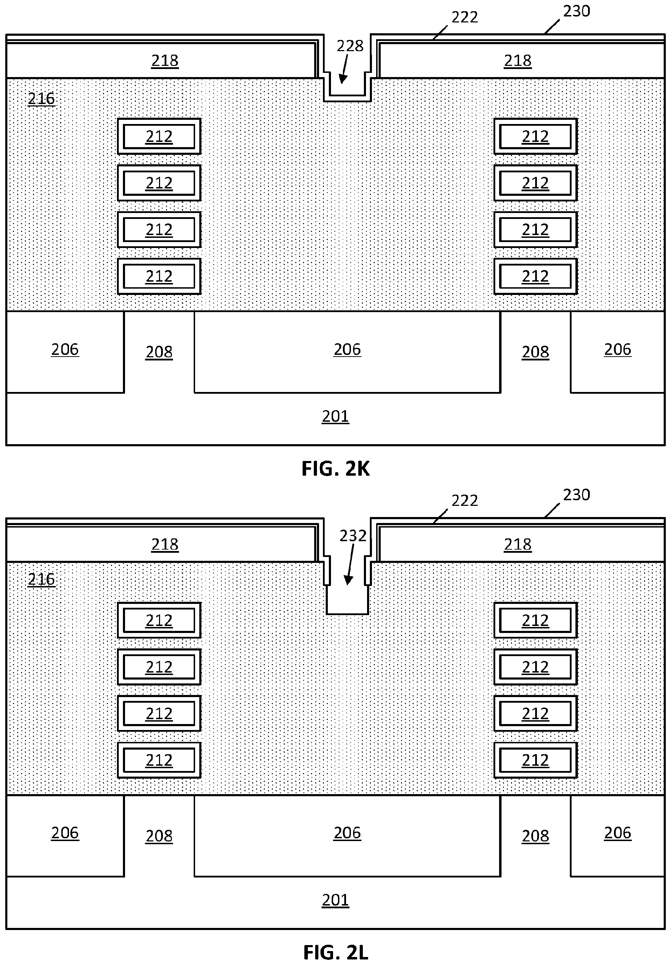

Figure 2K illustrates another cross-section view of the structure shown in Figure 2J following the formation of another passivation layer 230 within deeper opening 228 to protect the sidewalls of deeper opening 228, according to some embodiments. Portions of passivation layer 230 may be formed on prior passivation layer 224 on the sidewalls of opening 228. The example deposition process used to form passivation layer 230 may be the same as that used to form the prior passivation layer 224. Passivation layer 230 may be provided to protect the sidewalls of the exposed portion of gate electrode 216 within deeper opening 228.

Figure 2L illustrates another cross-section view of the structure shown in Figure 2K following a first etch to break through the bottom surface of passivation layer 230 within opening 228 and a second etch to continue etching deeper into gate electrode 216, according to some embodiments. The etch process used to etch through the metal material of gate electrode 216 may be the same as discussed above with reference to Figure 2J. As a consequence of etching deeper into gate electrode 216, a deeper recess 232 is formed. Similar to before, any number of various flash operations may also be performed to clean up any byproducts and provide further sidewall protection.

According to some embodiments, the process of forming passivation layers, breaking through the bottom surface of such layers within the opening and etching through a portion of the gate electrode is repeated at least until the entire thickness of gate electrode 216 has been etched through. In some examples, the process is repeated at least 15 times, at least 20 times, or at least 25 times to form a low to no taper recess having a depth of 125 nm or more and that extends at least into a portion of dielectric fill 206, or into a portion of substrate 201. Each iteration may penetrate a distance through the gate structure, such as 5 to 10 nm per iteration. Iterations later in the cycle may penetrate a shorter distance of the gate structure and underlying dielectric and/or substrate than earlier iterations, due to factors such as loading changes as the trench depth increases. Any number of various flash operations may also be performed within a given cycle. Figure 2M illustrates a cross-section view of the structure following a given number of passivation-etch cycles to ultimately form a gate cut recess 236, according to some embodiments. Due to the carefully controlled passivation and etching operations performed at each cycle, gate cut recess 236 is formed one portion at a time to maintain a high degree of verticality.

Figure 2N illustrates another cross-section view of the structure shown in Figure 2M following the formation of gate cut 238 within gate cut recess 236 and the removal of masking structure 218 and any passivation layers used during the formation of gate cut recess 236, according to some embodiments. Gate cut 238 may be formed from one or more dielectric materials. For example, gate cut 238 may include only silicon oxide or silicon nitride. In some examples, gate cut 238 includes a first dielectric layer at the edges and a dielectric fill within a remaining volume. The first dielectric layer may include a high-k dielectric material (e.g. materials with a dielectric constant higher than that of silicon oxide) while the dielectric fill may include a low-k dielectric material (e.g. materials with a dielectric constant equal to or lower than that of silicon oxide).

According to some embodiments, gate cut 238 has an aspect ratio of 5:1 or greater, or 9:1 or greater, or 10:1 or greater, such as 11:1. According to some embodiments, gate cut 238 has a total height *h* that extends through an entire thickness of gate electrode 216 and into at least a portion of dielectric fill 206. In some examples, height *h* may be between about 160 nm and about 180 nm. According to some embodiments, gate cut 238 has a first width *w₁* at a top surface of gate cut 238 which is also at a top surface of gate electrode 216, and a second width *w₂* at a portion of gate cut 120 that crosses a bottom surface of gate electrode 216. In some examples, *w₁* is at most 2 nm or at most 1.5 nm greater than *w₂.* In some examples, *w₁* is at most 10% greater, at most 8% greater, or at most 5% greater than *w₂.* In some examples, *w₁* is less than 24 nm, such as the example case where *w₁* is between about 18 nm and about 20 nm and *w₂* is between about 17 nm and about 19 nm.

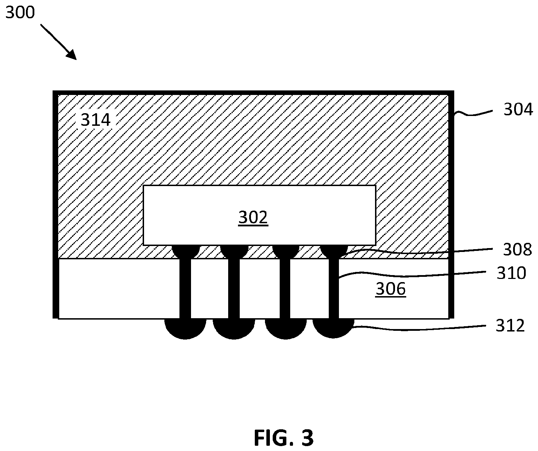

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

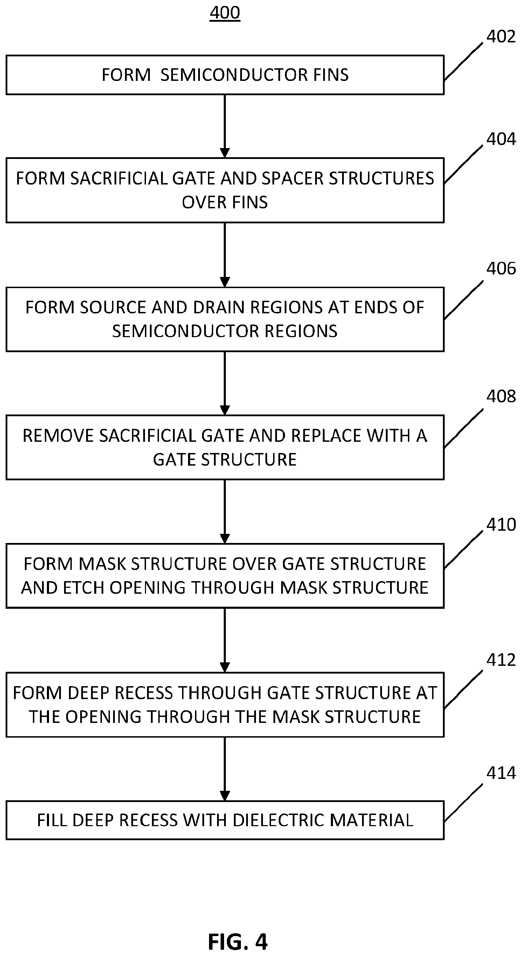

Figure 4 is a flow chart of a method 400 for forming at least a portion of an integrated circuit, according to an embodiment. Various operations of method 400 may be illustrated in Figures 2A - 2N. However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. For example, method 400 does not explicitly describe all processes that are performed to form common transistor structures. Some of the operations of method 400 may be performed in a different order than the illustrated order.

Method 400 begins with operation 402 where a plurality of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric fill is formed around subfin portions of the one or more fins. In some embodiments, the dielectric fill extends between each pair of adjacent parallel fins and runs lengthwise in the same direction as the fins. In some embodiments, the anisotropic etching process that forms the fins also etches into a portion of the substrate and the dielectric fill may be formed within the recessed portions of the substrate. Accordingly, the dielectric fill acts as shallow trench isolation (STI) between adjacent fins. The dielectric fill may be any suitable dielectric material, such as silicon oxide.

Method 400 continues with operation 404 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a cross-hatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 400 continues with operation 406 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 400 continues with operation 408 where the sacrificial gate is removed and replaced with a gate structure. The sacrificial gate may be removed using an isotropic etching process that selectively removes all of the material from the sacrificial gate, thus exposing the various fins between the set of spacer structures. In the example case where GAA transistors are used, any sacrificial layers within the exposed fins between the spacer structures may also be removed to release nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples.

Method 400 continues with operation 410 where a mask structure is formed over the gate structure and an opening is formed through the mask structure to expose a portion of the underlying gate electrode. According to some embodiments, the opening through the mask structure is at a location where a gate cut is to be formed through the underlying gate electrode. The mask structure may include any number of hard mask layers, such as any dielectric layers or carbon hard mask layers. The opening may be formed using a directional RIE process.

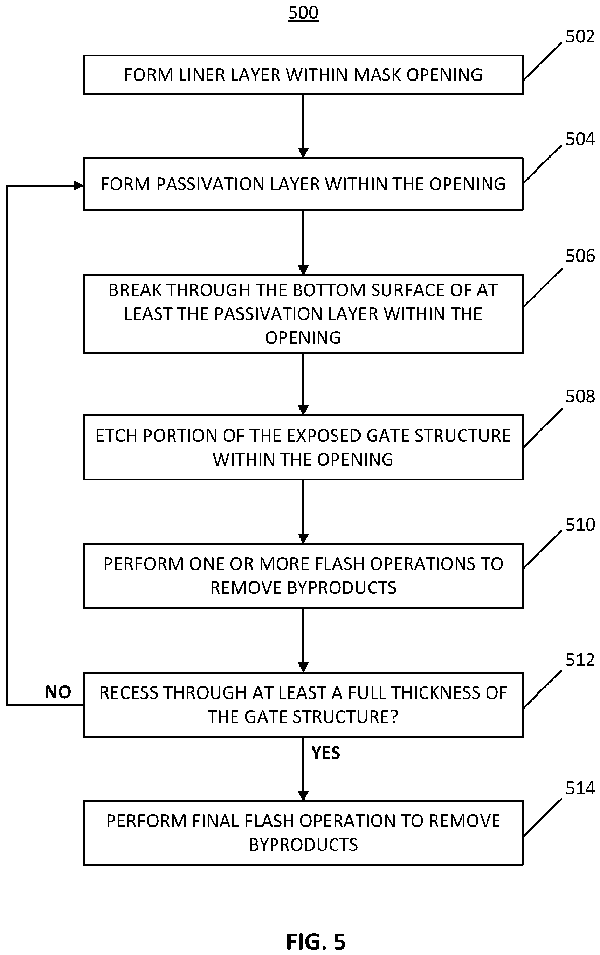

Method 400 continues with operation 412 where a deep recess is formed through the gate structure beneath the opening through the mask structure. According to some embodiments, the deep recess has a high height-to-width aspect ratio of at least 10:1 and extends through at least an entire thickness of the gate electrode. In some examples, the deep recess extends into the dielectric fill between devices or into the underlying substrate. Further details regarding the formation of the deep recess are provided by method 500 in FIG. 5.

Method 400 continues with operation 414 where the deep recess is filled with a dielectric material to form a gate cut through the gate structure. The gate cut may be formed from one or more dielectric materials. For example, the gate cut may include only silicon oxide or silicon nitride. In some examples, the gate cut includes a first dielectric layer at the edges and a dielectric fill within a remaining volume. The first dielectric layer may include a high-k dielectric material (e.g. materials with a dielectric constant higher than that of silicon oxide) while the dielectric fill may include a low-k dielectric material (e.g. materials with a dielectric constant equal to or lower than that of silicon oxide).

According to some embodiments, the gate cut has a height-to-width aspect ratio of 10:1 or greater, such as 11:1. According to some embodiments, the gate cut has a total height that extends through an entire thickness of the gate electrode and into at least a portion of the dielectric fill. The height of the gate cut may be between about 160 nm and about 180 nm. According to some embodiments, the gate cut has a first width at a top surface of the gate cut which may be substantially planar with a top surface of the gate structure, and a second width at a portion of the gate cut that crosses a bottom surface of the gate structure (e.g., the interface between the gate structure and the dielectric fill). In some examples, the first width of the gate cut is at most 2 nm greater or at most 1.5 nm greater than the second width of the gate cut. In some examples, the first width of the gate cut is at most 10% greater, at most 8% greater, or at most 5% greater than the second width of the gate cut. In some examples, the first width of the gate cut is between about 18 nm and about 20 nm and the second width of the gate cut is between about 17 nm and about 19 nm.

Figure 5 is a flow chart of a method 500 for forming the deep trench discussed above in operation 412 of method 400, according to an embodiment. Various operations of method 500 may be illustrated in Figures 2G - 2M. However, the correlation of the various operations of method 500 to the specific components illustrated in the aforementioned figures is not intended to imply any structural and/or use limitations. Rather, the aforementioned figures provide one example embodiment of method 500. Other operations may be performed before, during, or after any of the operations of method 500.

Method 500 begins with operation 502 where a liner layer is formed within at least the opening through the mask structure. The liner layer may be formed using atomic layer deposition (ALD) in a chamber with a pressure between 80 mTorr - 100 mTorr, a temperature between 90 °C and 140 °C, and gases containing helium and oxygen. In some embodiments, the liner layer includes a dielectric material, such as silicon oxide. The liner layer may be provided to tune the critical dimension of the top width of the resulting gate cut. Due to its conformal structure, the liner layer forms at least along the sidewalls of the opening through the mask structure.

Method 500 continues with operation 504 where a passivation layer is formed at least within the opening. In some embodiments, the passivation layer includes a dielectric material, such as silicon oxide. The passivation layer may be deposited using chemical vapor deposition (CVD) in a chamber with a pressure between 5 mTorr - 20 mTorr, a temperature between 90 °C and 140 °C, and gases containing helium, oxygen, and silicon tetrachloride (SiCl₄). The gases may be introduced into the chamber at different flow rates. For example, helium may be introduced at a flow rate between 400 and 800 sccm, oxygen may be introduced at a flow rate between 50 and 100 sccm, and SiCl₄ may be introduced at a flow rate between 70 and 120 sccm. The passivation layer forms at least on the sidewalls of the opening and is used to protect the sidewalls during each etching process to reduce lateral etching of the gate electrode, thus yielding less tapering in the sidewall profile.

Method 500 continues with operation 506 where an etching process is performed to break through at least the passivation layer (and possibly also the liner layer) at the bottom of the opening. In this way, the passivation layer (and in some cases, the liner layer also) remain on the sidewalls of the opening to protect them during the subsequent metal etching process. An RIE etching process may be used to punch through the portions of at least the passivation layer on the bottom surface of the opening. According to some embodiments, the RIE process takes place in chamber having a pressure between 5 mTorr and 20 mTorr, a temperature between 90 °C and 140 °C, and gases containing helium, one or more hydrocarbons such as methane (CH₄), and one or more fluoro-hydrocarbons such as carbon tetrafluoride (CF₄) or fluoroform (CHF₃). The gases may be introduced into the chamber at different flow rates. For example, helium may be introduced at a flow rate between 50 and 150 sccm, CH₄ may be introduced at a flow rate between 50 and 150 sccm, and CHF₃ may be introduced at a flow rate between 5 and 30 sccm. The use of CH₄ during the etching process can help with adding carbon-based passivation to the sidewalls and can also reduce the etching of any exposed portions of the source or drain regions.

Method 500 continues with operation 508 where the exposed portion of the gate electrode within the opening is etched. According to some embodiments, this etching process does not etch through the entire thickness of the gate electrode in a single etch, but rather only etches a fraction of the thickness of the gate electrode (such as around 5-10 nm of etch depth into the gate electrode). The RIE process may be tuned to selectively etch the metal material of the gate electrode. According to some embodiments, the metal etching process takes place in chamber having a pressure between 10 mTorr and 25 mTorr, a temperature between 90 °C and 140 °C, and gases containing boron trichloride (BCl₃), argon, and methane (CH₄). The gases may be introduced into the chamber at different flow rates. For example, BCl₃ may be introduced at a flow rate between 100 and 300 sccm, CH₄ may be introduced at a flow rate between 10 and 40 sccm, and argon may be introduced at a flow rate between 100 and 300 sccm. According to some embodiments, a high RF power may also be applied in the chamber between 1000 W and 3000 W to help break down the BCl₃ molecules and reduce the buildup of undesirable surface residue. The CH4 may once again be used to help reduce the etching of any exposed portions of the source or drain regions. In some embodiments, an additional bias RF power between 0 and 1000 W is applied to a chuck holding the wafer to vertically direct the species and reactants to the etch front.

Method 500 continues with operation 510 where one or more flash operations are performed to remove any byproducts produced by the metal etch. According to some embodiments, a first flash operation may be performed in a chamber having a pressure between 5 mTorr and 10 mTorr, a temperature between 90 °C and 140 °C, and gases containing argon, hydrogen, chlorine, methane (CH₄), helium, and oxygen. The first flash operation may be used to remove any polymer byproducts left behind from the metal etching process and/or to passivate any exposed portions of the source or drain regions. According to some embodiments, a second flash operation may be performed in a chamber having a pressure between 5 mTorr and 10 mTorr, a temperature between 90 °C and 140 °C, and gases containing methane (CH₄) and helium. The second flash operation may be used to particularly remove any polymer byproducts from the sidewalls to prevent sidewall corrosion. According to some embodiments, a third flash operation may be performed in a chamber having a pressure between 5 mTorr and 25 mTorr, a temperature between 90 °C and 140 °C, and a gas containing oxygen. The third flash operation may be used to cure some boron-based polymers left behind on the sidewalls to enhance the sidewall protection for later etching processes. Any of these example flash operations may be performed and they may be performed in any order.

Method 500 continues with operation 512 where a determination is made whether the etched recess has extended through an entire thickness of the gate structure (and more specifically, the gate electrode). The determination may be based on the use of inspection tools or ion scattering data to determine whether the underlying dielectric fill has been exposed at the bottom of the recess after each etching process. In some embodiments, a predetermined number of cyclic etch processes are performed which result in a recess that extends through the entire thickness of the gate structure, and once that number is reached, the process is completed. For example, a total of 15 metal etch processes, 20 metal etch process, or 25 metal etch processes may be performed.

If the recess has not yet extended through the entire thickness of the gate structure, then method 500 loops back to operation 504 and repeats the formation of the passivation layer, break through etching of the passivation layer, etching of the metal gate electrode, and the one or more flash operations before again determining if the recess now extends through the entire thickness of the gate structure. If the recess has been determined to extend through the entire thickness of the gate structure, the method 500 proceeds to operation 514 where a final flash operation may be performed to remove etch byproducts. The final flash operation may be similar to any one or more of the aforementioned flash operations. In some embodiments, the final flash operation contains a higher concentration of hydrogen in the chamber to provide enhanced protection to any exposed portions of the source or drain regions. At this point, the methodology may continue with filling the deep recess with dielectric material, as described above with respect to operation 414 of method 400.

### Example System

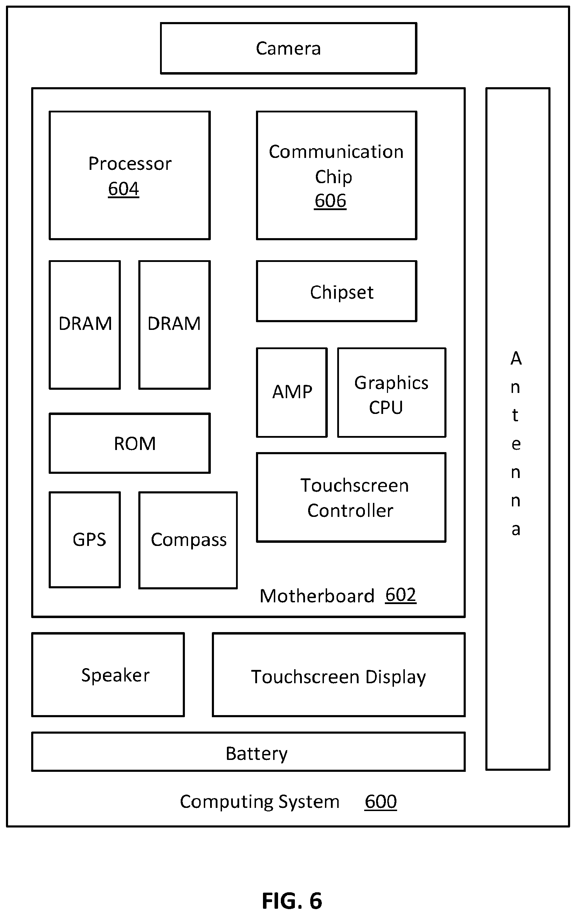

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment, such as a module including an integrated circuit on a substrate, the substrate having semiconductor devices and at least one gate cut having a very high height-to-width aspect ratio (e.g., height-to-width aspect ratio of 10:1 or greater, in some examples). In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multistandard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source region to a first drain region and a first gate structure extending in a second direction over the first semiconductor region, a second semiconductor device having a second semiconductor region extending in the first direction from a second source region to a second drain region and a second gate structure extending in the second direction over the second semiconductor region, and a gate cut between and separating the first gate structure and the second gate structure. The gate cut has a dielectric material and has a height-to-width aspect ratio of at least 8:1.

Example 2 includes the integrated circuit of Example 1, wherein the gate cut has a height greater than 140 nm, and height-to-width aspect ratio of at least 9:1.

Example 3 includes the integrated circuit of Example 1, wherein the gate cut has a height greater than 150 nm, and height-to-width aspect ratio of at least 10:1.

Example 4 includes the integrated circuit of any one of Examples 1-3, wherein the gate cut has a height between about 150 nm and about 180 nm.

Example 5 includes the integrated circuit of any one of Examples 1-4, wherein the first semiconductor region comprises a plurality of first semiconductor nanoribbons and the second semiconductor region comprises a plurality of second semiconductor nanoribbons

Example 6 includes the integrated circuit of any one of Examples 1-5, wherein the first gate structure includes a first gate dielectric around the first semiconductor region, and the second gate structure includes a second gate dielectric around the second semiconductor region, and wherein the first gate dielectric and the second gate dielectric are not present on any sidewall of the gate cut.

Example 7 includes the integrated circuit of any one of Examples 1-6, wherein the gate cut has a first width at a top surface of the first gate structure and the second gate structure, and a second width at a bottom surface of the first gate structure and the second gate structure, the first width being at most 2 nm greater than the second width.

Example 8 includes the integrated circuit of any one of Examples 1-7, wherein the gate cut has a first width at a top surface of the first gate structure and the second gate structure, and a second width at a bottom surface of the first gate structure and the second gate structure, the first width being at most 10% greater than the second width.

Example 9 is a printed circuit board comprising the integrated circuit of any one of Examples 1-8.

Example 10 is an electronic device that includes a chip package comprising one or more dies. At least one of the one or more dies includes a first semiconductor device having a first semiconductor region extending in a first direction between a first source region and a first drain region and a first gate structure extending in a second direction over the first semiconductor region, a second semiconductor device having a second semiconductor region extending in the first direction between a second source region and a second drain region and a second gate structure extending in the second direction over the second semiconductor region, and a gate cut between and separating the first gate structure and the second gate structure. The gate cut has a first width at a top surface of the first gate structure and the second gate structure, and a second width at a bottom surface of the first gate structure and the second gate structure. The first width is 20 nm or less and at most 2 nm greater than the second width, and the gate cut has a height greater than 125 nm.

Example 11 includes the electronic device of Example 10, wherein the gate cut has a height between about 160 nm and about 180 nm.

Example 12 includes the electronic device of Example 10 or 11, wherein the first semiconductor region comprises a plurality of first semiconductor nanoribbons and the second semiconductor region comprises a plurality of second semiconductor nanoribbons.

Example 13 includes the electronic device of Example 10, wherein the first width is 15 nm or less, and the height of the gate cut is in the range of 150 nm to 200 nm.

Example 14 includes the electronic device of any one of Examples 10-13, wherein the first gate structure includes a first gate dielectric around the first semiconductor region, and the second gate structure includes a second gate dielectric around the second semiconductor region.

Example 15 includes the electronic device of Example 14, wherein the first gate dielectric and the second gate dielectric are not present on any sidewall of the gate cut.

Example 16 includes the electronic device of any one of Examples 10-15, wherein the gate cut comprises a dielectric material and has a height-to-width aspect ratio of at least 5:1.

Example 17 includes the electronic device of any one of Examples 10-16, wherein the gate cut has a first width at a top surface of the first gate structure and the second gate structure, and a second width at a bottom surface of the first gate structure and the second gate structure, the first width being at most 10% greater than the second width.

Example 18 includes the electronic device of any one of Examples 10-17, further comprising a printed circuit board, wherein the chip package is coupled to the printed circuit board.

Example 19 is a method of forming an integrated circuit. The method includes forming a first fin comprising semiconductor material and a second fin comprising semiconductor material, the first and second fins extending above a substrate and each extending in a first direction; forming a gate structure extending over the first fin and the second fin in a second direction different from the first direction; forming a recess through the gate structure between the first fin and the second fin; and forming a dielectric material within the recess. Forming the recess includes (i) forming an opening through a hard mask layer over the gate structure, (ii) forming a liner material within the opening, (iii) forming a passivation layer within the opening, (iv) etching through at least the passivation layer at a bottom of the opening, (v) etching through a portion of the gate structure, and (vi) repeating (iii) - (v) until the recess extends through at least an entire thickness of the gate structure.

Example 20 includes the method of Example 19, wherein forming the liner material comprises forming the liner using atomic layer deposition (ALD) or plasma enhanced atomic layer deposition (PEALD).

Example 21 includes the method of Example 19 or 20, wherein forming the passivation layer comprises forming the passivation layer using chemical vapor deposition (CVD) or plasma enhanced chemical vapor deposition (PECVD).

Example 22 includes the method of Example 21, wherein forming the passivation layer comprises using a first CVD process having a first RF energy and a second CVD process having a second RF energy different from the first RF energy.

Example 23 includes the method of any one of Examples 19-22, wherein etching through at least the passivation layer comprises etching with a CH₄-based gas or a CF₄-based gas.

Example 24 includes the method of any one of Examples 19-23, wherein etching through a portion of the gate structure comprises etching with a BCl₃/Cl₂ gas.

Example 25 is an integrated circuit that includes a first semiconductor device having a first semiconductor region extending in a first direction from a first source region to a first drain region and a first gate structure extending in a second direction over the first semiconductor region, a second semiconductor device having a second semiconductor region extending in the first direction from a second source region to a second drain region and a second gate structure extending in the second direction over the second semiconductor region, and a gate cut between and separating the first gate structure and the second gate structure. The gate cut includes a dielectric material and has less than 2 nm of sidewall taper between a top surface of the first gate structure and the second gate structure and a bottom surface of the first gate structure and the second gate structure.

Example 26 includes the integrated circuit of Example 25, wherein the gate cut has a height between about 150 nm and about 180 nm.

Example 27 includes the integrated circuit of Example 25 or 26, wherein the first semiconductor region comprises a plurality of first semiconductor nanoribbons and the second semiconductor region comprises a plurality of second semiconductor nanoribbons.

Example 28 includes the integrated circuit of Example 27, wherein the plurality of first semiconductor nanoribbons and the plurality of second semiconductor nanoribbons comprise germanium, silicon, or a combination thereof.

Example 29 includes the integrated circuit of any one of Examples 25-28, wherein the first gate structure includes a first gate dielectric around the first semiconductor region, and the second gate structure includes a second gate dielectric around the second semiconductor region.

Example 30 includes the integrated circuit of Example 29, wherein the first gate dielectric and the second gate dielectric are not present on any sidewall of the gate cut.

Example 31 includes the integrated circuit of any one of Examples 25-30, wherein the gate cut has a height-to-width aspect ratio of at least 5:1.

Example 32 includes the integrated circuit of any one of Examples 25-31, wherein the gate cut has a first width at the top surface of the first gate structure and the second gate structure, and a second width at the bottom surface of the first gate structure and the second gate structure, the first width being at most 10% greater than the second width.

Example 33 is a printed circuit board comprising the integrated circuit of any one of Examples 25-32.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending in a first direction from a first source region to a first drain region, and a first gate structure extending in a second direction over the first semiconductor region;
a second semiconductor device having a second semiconductor region extending in the first direction from a second source region to a second drain region, and a second gate structure extending in the second direction over the second semiconductor region; and
a gate cut between and separating the first gate structure and the second gate structure, the gate cut comprising a dielectric material and having a height-to-width aspect ratio of at least 8:1.

2. The integrated circuit of claim 1, wherein the gate cut has a height greater than 140 nm, and height-to-width aspect ratio of at least 9:1.

3. The integrated circuit of claim 1, wherein the gate cut has a height greater than 150 nm, and height-to-width aspect ratio of at least 10:1.

4. The integrated circuit of any one of claims 1 through 3, wherein the gate cut has a height between about 150 nm and about 180 nm.

5. The integrated circuit of any one of claims 1 through 4, wherein the first semiconductor region comprises a plurality of first semiconductor nanoribbons and the second semiconductor region comprises a plurality of second semiconductor nanoribbons.

6. The integrated circuit of any one of claims 1 through 5, wherein the first gate structure includes a first gate dielectric around the first semiconductor region, and the second gate structure includes a second gate dielectric around the second semiconductor region, and wherein the first gate dielectric and the second gate dielectric are not present on any sidewall of the gate cut.

7. The integrated circuit of any one of claims 1 through 6, wherein the gate cut has a first width at a top surface of the first gate structure and the second gate structure, and a second width at a bottom surface of the first gate structure and the second gate structure, the first width being at most 2 nm greater than the second width.

8. The integrated circuit of any one of claims 1 through 7, wherein the gate cut has a first width at a top surface of the first gate structure and the second gate structure, and a second width at a bottom surface of the first gate structure and the second gate structure, the first width being at most 10% greater than the second width.

9. A printed circuit board comprising the integrated circuit of any one of claims 1 through 8.

10. A method of forming an integrated circuit, comprising:
forming a first fin comprising semiconductor material and a second fin comprising semiconductor material, the first and second fins extending above a substrate and each extending in a first direction;
forming a gate structure extending over the first fin and the second fin in a second direction different from the first direction;
forming a recess through the gate structure between the first fin and the second fin, wherein forming the recess comprises
(i) forming an opening through a hard mask layer over the gate structure,
(ii) forming a liner material within the opening,
(iii) forming a passivation layer within the opening,
(iv) etching through at least the passivation layer at a bottom of the opening,
(v) etching through a portion of the gate structure, and
(vi) repeating (iii) - (v) until the recess extends through at least an entire thickness of the gate structure; and
forming a dielectric material within the recess.

11. The method of claim 10, wherein forming the liner material comprises forming the liner using atomic layer deposition (ALD) or plasma enhanced atomic layer deposition (PEALD).

12. The method of claim 10 or 11, wherein forming the passivation layer comprises forming the passivation layer using chemical vapor deposition (CVD) or plasma enhanced chemical vapor deposition (PECVD).

13. The method of claim 12, wherein forming the passivation layer comprises using a first CVD process having a first RF energy and a second CVD process having a second RF energy different from the first RF energy.

14. The method of any one of claims 10 through 13, wherein etching through at least the passivation layer comprises etching with a CH₄-based gas or a CF₄-based gas.

15. The method of any one of claims 10 through 14, wherein etching through a portion of the gate structure comprises etching with a BCl₃/Cl₂ gas.
